# FASCICULE DE BREVET EUROPEEN

(11) **EP 3 752 843 B1**
(45) Date de publication et mention de la délivrance du brevet: **29.06.2022**
(21) Numéro de dépôt: 19706926.3
(22) Date de dépôt: 14.02.2019
(51) Int. Cl.: G01R 23/163, G01R 23/17, G01R 29/08

(54) **DISPOSITIF ET PROCÉDÉ D'ANALYSE EN FRÉQUENCE D'UN SIGNAL**
VORRICHTUNG UND VERFAHREN ZUR FREQUENZANALYSE EINES SIGNALS
DEVICE AND METHOD FOR FREQUENCY ANALYSIS OF A SIGNAL

(30) Priorité: 16.02.2018 FR 1800147
(43) Date de publication de la demande: 23.12.2020
(73) Titulaire: THALES, 92400 Courbevoie (FR)
(72) Inventeur: DEBUISSCHERT, Thierry, 91767 PALAISEAU (FR); MAYER, Ludovic, 91767 PALAISEAU (FR)
(74) Mandataire: Lavoix
(86) Numéro de dépôt international: PCT/EP2019/053680
(87) Numéro de publication internationale: WO 2019/158646

(56) Documents cités:
- WO-A1-2017/062735
- FR-A1- 3 027 681
- CHIPAUX M ET AL: "Wide bandwidth instantaneous radio frequency spectrum analyzer based on nitrogen vacancy centers in diamond", APPLIED PHYSICS LETTERS, A I P PUBLISHING LLC, US, vol. 107, no. 23, 7 décembre 2015 (2015-12-07), XP012203138, ISSN: 0003-6951, DOI: 10.1063/1.4936758 [extrait le 1901-01-01]

## Description

La présente invention concerne un dispositif d'analyse en fréquence d'un signal. La présente invention se rapporte également à un procédé correspondant d'analyse en fréquence d'un signal.

La présente invention concerne le domaine de l'analyse en fréquence d'un signal, c'est-à-dire l'identification de la fréquence des composantes fréquentielles d'un signal inconnu ainsi que la détermination des amplitudes des composantes fréquentielles. Plus spécifiquement, le domaine considéré est le domaine hyperfréquence. Un signal dont la fréquence est typiquement comprise entre quelques mégahertz (MHz) et quelques centaines de gigahertz (GHz) est considéré comme un signal hyperfréquence.

L'analyse de spectre des signaux hyperfréquence est faite soit de manière analogique, soit de manière numérique.

De manière analogique, il est fait varier la fréquence d'un oscillateur local qui est hétérodyné avec le signal à mesurer. Le balayage de fréquence empêche d'avoir une acquisition instantanée de tout le spectre.

Il est possible de mesurer la totalité du spectre utile de manière instantanée avec des techniques état solide comme la technique dite SHB (sigle pour « Spectral Hole Burning » qui peut se traduire par « creusement de trou spectral »), mais une limitation de cette technique est la nécessité d'utiliser un cristal refroidi à température cryogénique.

Dans le cas numérique, un signal entrant est numérisé à l'aide d'un convertisseur analogique numérique puis une transformée de Fourier rapide (sigle FFT pour « Fast Fourier Transform ») est appliquée sur le signal numérisé.

Toutefois, une telle technique est limitée par la dynamique des convertisseurs fonctionnant à haute fréquence.

Il est à noter d'autres techniques d'analyse de spectre des signaux hyperfréquences sont également connues des documents FR 3 027 681 A1, WO 20171062735 A1 et de l'article de M. CHIPAUX et al. intitulé "Wide bandwidth instantaneous radio frequency spectrum analyzer based on nitrogen vacancy centers in diamond" et publié dans la revue APPLIED PHYSICS LETTERS, volume 107, numéro 23 en date du 7 décembre 2015.

Il existe donc un besoin pour un dispositif d'analyse d'un signal hyperfréquence qui présente de meilleures performances.

Pour cela, la description propose un dispositif d'analyse en fréquence d'un signal comprenant un cristal de diamant présentant une maille cristalline, une bande de valence et une bande de conduction, le cristal comprenant des centres NV dans la maille cristalline, chaque centre NV étant constitué d'un atome d'azote substitué à un atome de carbone et couplé à une lacune, le couple atome d'azote et lacune constituant un centre coloré dans la maille cristalline, le cristal de diamant présentant au moins une zone comportant plusieurs sous-zones ayant chacune une fréquence de résonance entre les niveaux d'énergie du centre NV⁻ dans laquelle, pour chacune des sous-zones, lorsque la sous-zone est en présence d'une excitation optique ou électrique, des charges sont générées dans la bande de conduction, et, en présence d'un signal présentant au moins une fréquence égale à la fréquence de résonance de la sous-zone, la quantité de charges varie avec l'amplitude de la composante fréquentielle du signal à la fréquence de résonance. Le dispositif d'analyse comprend une unité d'excitation propre à exciter optiquement ou électriquement chaque sous-zone, une unité d'injection propre à injecter un signal pour que la sous-zone soit en présence du signal, un générateur de champ magnétique configuré pour générer un champ magnétique sur chaque sous-zone, le champ magnétique présentant une variation spatiale d'amplitude selon une première direction et un détecteur. Le détecteur est propre à détecter la fréquence de résonance de chaque sous-zone de la zone, le détecteur comportant un contact électrique pour chaque sous-zone dont le détecteur est propre à détecter la fréquence de résonance, chaque contact électrique étant propre à détecter les charges créées dans la sous-zone considérée dans la bande de conduction du cristal pour obtenir un signal lorsque la sous-zone est simultanément en présence d'une excitation optique ou électrique provenant de l'unité d'excitation et d'un signal injecté par l'unité d'injection, et le détecteur comporte un circuit de lecture en silicium connecté aux contacts pour convertir chaque signal obtenu en un signal converti, chaque signal converti étant fonction de l'amplitude de la composante fréquentielle à la fréquence de résonance de la sous-zone.

Suivant des modes de réalisation particuliers, le dispositif comprend une ou plusieurs des caractéristiques suivantes, prise(s) isolément ou suivant toutes les combinaisons techniquement possibles :
- la distance entre deux contacts est inférieure à 300 nanomètres.
- le circuit de lecture est un circuit CMOS.
- le circuit de lecture comporte une pluralité d'unités de traitement, chaque unité de traitement étant reliée à un contact respectif.
- chaque unité de traitement est reliée à un contact respectif par un plot d'indium ou par un fil.
- le détecteur comporte, en outre, un circuit imprimé, le circuit imprimé connectant le circuit de lecture aux contacts.
- chaque contact est formé de deux électrodes interdigitées selon une deuxième direction, la deuxième direction étant perpendiculaire à la première direction.
- le cristal est une couche s'étendant principalement selon un plan et présentant un axe 111, l'axe 111 appartenant au plan.
- le nombre de contacts est supérieur à 500.

La présente description a également pour objet un procédé d'analyse en fréquence d'un signal, le procédé comportant une étape de fourniture d'un cristal de diamant présentant une maille cristalline, une bande de valence et une bande de conduction, le cristal comprenant des centres NV dans la maille cristalline, chaque centre NV étant constitué d'un atome d'azote substitué à un atome de carbone et couplé à une lacune, le couple atome d'azote et lacune constituant un centre coloré dans la maille cristalline, le cristal présentant au moins une zone comportant plusieurs sous-zones ayant chacune une fréquence de résonance entre les niveaux d'énergie du centre NV⁻ dans laquelle, pour chacune des sous-zones, lorsque la sous-zone est simultanément en présence d'une excitation optique ou électrique et d'un signal présentant au moins une fréquence égale à la fréquence de résonance de la sous-zone, apparaît une modification de la quantité de charges générées dans la bande de conduction. Le procédé comportant également une étape d'excitation optique ou électrique de chaque sous-zone du cristal de diamant, d'injection d'un signal pour que la sous-zone soit en présence du signal, de génération d'un champ magnétique sur chaque sous-zone, le champ magnétique présentant une variation spatiale d'amplitude selon une première direction et de détection de la fréquence de résonance de chaque sous-zone de la zone en détectant les charges créées dans chaque sous-zone dans la bande de conduction du diamant à l'aide d'un contact électrique propre à chaque sous-zone, pour obtenir un signal et en convertissant chaque signal obtenu en un signal converti avec un circuit de lecture en silicium connecté aux contacts, chaque signal converti étant fonction de la composante fréquentielle du signal à la fréquence de résonance de la sous-zone.

D'autres caractéristiques et avantages de l'invention apparaîtront à la lecture de la description qui suit de modes de réalisation de l'invention, donnée à titre d'exemple uniquement et en référence aux dessins qui sont :
- figure 1, une vue schématique d'un exemple de dispositif d'analyse d'un signal hyperfréquence, et
- figure 2, une vue schématique d'un autre exemple de dispositif d'analyse d'un signal hyperfréquence.

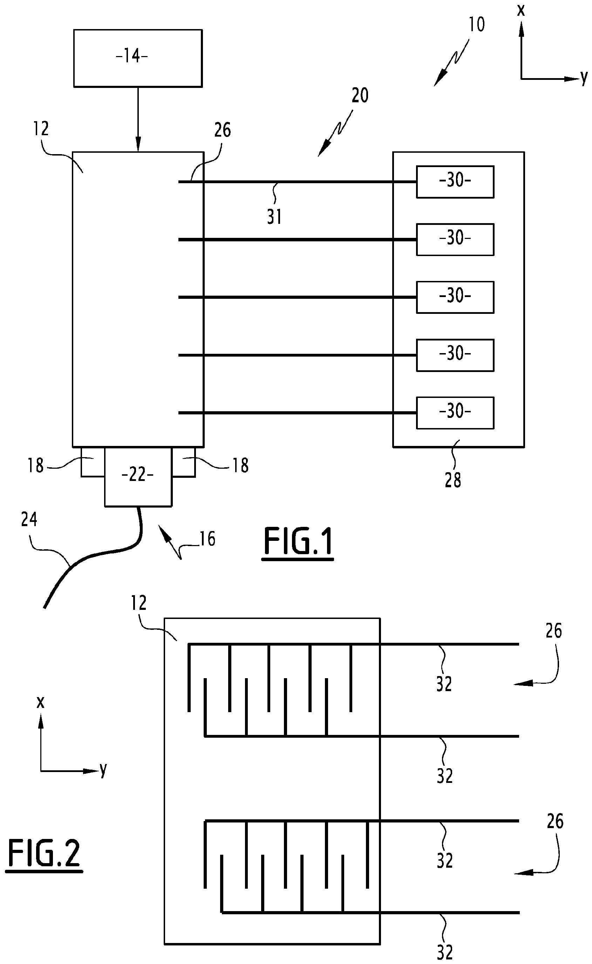

Un dispositif 10 d'analyse est illustré schématiquement sur la figure 1.

Le dispositif 10 d'analyse est propre à analyser un signal.

Dans le contexte de l'invention, le terme « analyser » renvoie à une des actions suivantes : identifier la fréquence de composantes fréquentielles d'un signal et déterminer les amplitudes de composantes fréquentielles d'un signal.

Le dispositif 10 d'analyse est ainsi adapté pour identifier la fréquence de composantes fréquentielles d'un signal et adapté pour déterminer les amplitudes de composantes fréquentielles d'un signal.

Le dispositif 10 d'analyse est ainsi un analyseur de spectre.

Dans l'exemple décrit, le dispositif 10 d'analyse est un dispositif d'analyse d'un signal hyperfréquence, un signal hyperfréquence présentant une fréquence comprise entre 1 MHz et quelques 100 GHz.

Le dispositif 10 comporte un cristal 12 de diamant, une unité d'excitation 14, une unité d'injection du signal à analyser 16 un générateur de champ magnétique 18 et un détecteur 20 formé de contacts 26 et d'un circuit de lecture 28 comportant un ensemble d'unités de traitement 30.

Le cristal 12 de diamant présente une maille cristalline. Les niveaux d'énergie sont caractérisés par une bande de valence et une bande de conduction.

Le cristal 12 comprend des centres NV dans la maille cristalline.

Les centres NV sont présents à proximité de la surface ou en volume.

Chaque centre NV est constitué d'un atome d'azote substitué à un atome de carbone et couplé à une lacune, le couple atome d'azote et lacune constituant un centre coloré dans la maille cristalline.

Plus précisément, un centre NV est un défaut ponctuel de la maille cristalline du diamant, formé par un atome d'azote (N) qui se substitue à un atome de carbone et auquel vient se coupler une lacune dans un site adjacent de la maille cristalline (V pour « vacancy » signifiant « lacune » en français).

L'obtention de centres NV dans le diamant est bien maîtrisée. Des diamants de grande taille sont produits par un procédé CVD (pour Chemical Vapor Deposition en anglais signifiant littéralement « dépôt chimique en phase vapeur ») typiquement sous forme de parallélépipèdes de plusieurs millimètres de côté et de plusieurs centaines de micromètres d'épaisseur. Les centres NV peuvent être créés par implantation ionique d'atomes d'azote. Les centres NV peuvent également être créés en incorporant de l'azote de manière contrôlée au cours de la croissance du diamant par la méthode de « dopage in-situ ». A la fin, le diamant est recuit (800°C) pour que les lacunes se recombinent avec les impuretés d'azote pour former les centres NV. Les centres NV sont créés en volume ou en couches uniformes à proximité de la surface.

L'ensemble azote plus lacune formant le centre NV constitue ainsi un "atome artificiel", incorporé au sein de la matrice de diamant et détectable à l'échelle individuelle. Un centre NV possède une localisation bien précise qui ne varie pas dans le temps.

Le centre NV peut exister avec plusieurs états de charge différents. L'état utilisé dans l'exemple décrit est le centre NV⁻, qui a capturé un électron supplémentaire par rapport à son état neutre. Le centre NV⁻ présente une résonance de spin électronique correspondant aux transitions entre le niveau mₛ = 0 et les niveaux mₛ = -1 et mₛ = +1 des niveaux fondamental ³A₂ et excité ³E. En l'absence de champ magnétique, les niveaux mₛ = -1 et mₛ = +1 sont dégénérés. L'application d'un champ magnétique extérieur se traduit par une levée de dégénérescence par effet Zeeman entre les niveaux de spin mₛ = -1 et mₛ = 1, tant pour le niveau fondamental ³A₂ que le niveau excité ³E. L'effet Zeeman résulte d'un couplage entre le champ magnétique extérieur et le moment magnétique des électrons entraînant la levée de dégénérescence. Le cristal 12 de diamant présente au moins une zone comportant plusieurs sous-zones ayant chacune une fréquence de résonance entre les niveaux d'énergie du centre NV dans laquelle, pour chacune des sous-zones, lorsque la sous-zone est en présence d'une excitation optique ou électrique, des charges sont générées dans la bande de conduction. En présence d'un signal hyperfréquence présentant au moins une fréquence égale à la fréquence de résonance de la sous-zone, la quantité de charges transférées dans la bande de conduction est modifiée.

Avantageusement, le cristal 12 est de géométrie planaire, le plan comportant deux directions indiquées par les axes X et Y sur la figure 1. Dans la suite, la première direction est appelée première direction X et la deuxième direction est appelée deuxième direction Y.

L'unité d'excitation 14 est propre à exciter chaque sous-zone.

Plus précisément, l'unité d'excitation 14 est propre à exciter les centres NV contenus dans les sous-zones.

Selon le mode de réalisation de la figure 1, l'unité d'excitation 14 est propre à exciter chaque sous-zone avec une excitation optique.

L'unité d'excitation 14 est une diode laser.

La diode laser est propre à émettre dans le domaine visible, notamment dans une bande de longueur d'ondes comprise entre 400 nanomètres (nm) et 650 nm.

La diode laser est en contact avec le cristal 12.

Plus généralement, l'unité d'excitation 14 est une source lumineuse, notamment un laser de pompage, telle une diode laser.

L'unité d'injection 16 est propre à injecter un signal à analyser pour que chaque sous-zone soit en présence du signal à analyser.

Selon le mode de réalisation décrit, l'unité d'injection 16 est une antenne émettrice 22 et un câble 24.

L'antenne émettrice 22 est disposée à proximité du cristal 12 et émet le signal à analyser.

L'antenne émettrice 22 comprend, par exemple, une boucle assurant l'obtention d'un champ uniforme au niveau du cristal 12.

Le câble 24 est un câble coaxial.

Le signal à analyser provient du câble 24 coaxial, dans lequel le signal circule.

Selon un mode de réalisation particulier, le câble 24 est relié à une antenne réceptrice pour mieux capter le signal.

Le générateur de champ magnétique 18 est configuré pour générer un champ magnétique sur chaque sous-zone, le champ magnétique présentant une variation spatiale d'amplitude selon la première direction X.

Avantageusement, la variation spatiale d'amplitude du champ magnétique est monotone.

Selon un mode de réalisation, la variation spatiale est une variation linéaire.

Par exemple, le générateur de champ magnétique 18 est propre à appliquer un gradient de champ de plusieurs centaines de T/m.

Selon un cas particulier, le générateur de champ magnétique 18 est un aimant néodyme.

Comme indiqué précédemment, le détecteur 20 comporte des contacts 26 et un circuit de lecture 28.

Le détecteur 20 est propre à détecter la fréquence de résonance de chaque sous-zone de la zone.

Plus précisément, le détecteur 20 comporte un contact 26 électrique pour chaque sous-zone dont le détecteur 20 est propre à détecter la fréquence de résonance.

Chaque contact 26 électrique est propre à détecter les charges créées dans la sous-zone considérée dans la bande de conduction du diamant pour obtenir un signal lorsque la sous-zone est simultanément en présence d'une excitation optique ou électrique provenant de l'unité d'excitation 14 et d'un signal injecté par l'unité d'injection 16.

Du fait de ce rôle de collection de charge(s), le contact 26 électrique peut également être désigné sous le terme d'électrode.

En outre, il est à noter que chaque contact 26 peut comporter une pluralité de points de contacts avec le cristal (voir notamment figure 2 décrite ultérieurement).

Le nombre de contacts 26 détermine la résolution en fréquence du détecteur 20.

Selon l'exemple décrit, les contacts 26 métalliques sont des pistes d'or avec une accroche sur le cristal 12 en tungstène.

Les contacts 26 sont déposés sur le cristal 12 de diamant, par exemple par une technique de lithographie.

La distance entre deux contacts 26 est notée d_{contact}.

La distance entre deux contacts 26 est définie comme la distance minimale entre deux points des contacts 26.

Avantageusement, la distance entre deux contacts 26 est la même pour tous les contacts 26.

Selon l'exemple décrit, la distance d_{contact} entre deux contacts 26 est comprise entre 10 nanomètres (nm) et 50 micromètres (µm).

La distance d_{contact} entre deux contacts 26 et la résolution voulue permet d'en déduire la taille du cristal 12. Typiquement, une distance d_{contact} entre deux contacts 26 de 1,0 µm et une résolution en fréquence d'1/1000^{ème} de la largeur de la bande spectrale du signal à analyser conduit à une longueur de cristal 12 de 1 mm.

Chaque charge collectée par un contact 26 forme un signal obtenu.

Le circuit de lecture 28 est propre à convertir chaque signal obtenu par les contacts 26 en un signal converti, chaque signal converti est propre à la fréquence de résonance de la sous-zone et est une fonction de l'amplitude de la composante fréquentielle correspondante. Cette fonction est constituée d'une partie constante liée au signal de fond produit par le centre NV et d'une partie proportionnelle à l'amplitude de la composante fréquentielle mesurée et qui se soustrait du fond. Pour avoir un signal directement proportionnel à l'amplitude de la composante fréquentielle mesurée, il faut donc traiter le signal pour en soustraire le fond.

Autrement formulé, le circuit de lecture 28 est une partie de traitement propre à traiter chaque signal électrique analogique provenant d'une pluralité de détecteurs. Le traitement comporte, par exemple, une amplification ou une numérisation. La partie de traitement comprend, pour chaque détecteur, une unité de traitement 30 spécifique.

L'espacement entre les unités de traitements 30 est appelé « pas » pour la suite.

Le circuit de lecture 28 est en silicium.

Par exemple, le circuit de lecture 28 est un circuit CMOS (pour l'anglais *« Complementary Metal Oxide Semiconductor* » renvoyant au terme « semiconducteur à oxyde de métal complémentaire »).

En variante, le circuit de lecture 28 est un dispositif à transfert de charge aussi désigné par l'acronyme CCD (pour l'anglais du « charge-coupled device », ou en français « dispositif à transfert de charge »).

A titre d'exemple, le circuit de lecture 28 est un amplificateur transimpédance permettant de lire le courant dans une résistance de charge ou un amplificateur de charge permettant de lire la charge d'une capacité. Un tel circuit de lecture 28 est connu pour fonctionner à bas bruit et être adapté à la détection de faibles charges.

Le circuit de lecture 28 est connecté aux contacts 26 pour convertir chaque signal obtenu en un signal converti, chaque signal converti étant fonction de l'amplitude de la composante fréquentielle correspondant à la fréquence de résonance de la sous-zone.

Cela signifie que chaque contact 26 est connecté à une unité de traitement 30 respective du circuit de lecture 28.

Par exemple, chaque unité de traitement 30 est reliée par un fil 31 à un contact 26 respectif.

En variante, chaque unité de traitement 30 est reliée par un plot d'indium à un contact 26 respectif.

Dans cette variante, le pas est égal à distance d_{contact} entre les contacts 26.

Selon un autre mode de réalisation, le détecteur 20 comporte, en outre, un circuit imprimé (aussi désigné par l'acronyme PCB renvoyant au terme anglais de *"printed circuit board"*) *.*

Le circuit imprimé connecte le circuit de lecture 28 aux contacts 26.

Plus précisément, le circuit imprimé comporte des pistes conductrices, chaque contact 26 étant relié à une unité de traitement 30 respective via une piste conductrice.

Le fonctionnement du dispositif 10 d'analyse est maintenant décrit en référence à un exemple de mise en oeuvre d'un procédé d'analyse d'un signal.

Le procédé comporte une étape d'excitation, une étape d'injection, une étape de génération et une étape de détection, ces étapes étant mises en oeuvre simultanément.

Lors de l'étape d'excitation, l'unité d'excitation 14 excite optiquement chaque sous-zone du cristal 12 de diamant.

Les électrons des centres NV sont ainsi pompés optiquement dans la bande de conduction.

Lors de l'étape d'injection, l'unité d'injection 16 injecte un signal à analyser pour que chaque sous-zone soit en présence du signal.

Lors de l'étape de génération, le générateur de champ magnétique 18 génère un champ magnétique sur chaque sous-zone.

Le champ magnétique modifie la fréquence de résonance dans chaque sous-zone par effet Zeeman.

Les étapes d'excitation, d'injection et de génération sont mises en œuvre simultanément pour que chaque sous-zone soit simultanément en présence de l'excitation optique, d'un signal injecté et du champ magnétique.

Lorsque la sous-zone est simultanément en présence d'une excitation optique et d'un signal présentant au moins une fréquence égale à la fréquence de résonance de la sous-zone, il se produit une modification du nombre de charges générées dans la bande de conduction, ce qui permet la détection du signal.

Lors de l'étape de détection, il est détecté l'amplitude de la composante fréquentielle à la fréquence de résonance de chaque sous-zone. Ainsi, l'étape de détection est une détection photoélectrique de l'état de spin des électrons des centres NV du cristal 12 de diamant.

Pour cela, chaque contact 26 collecte les charges générées dans la bande de conduction par les centres NV. Un signal est ainsi obtenu pour chaque contact 26.

Le signal est conduit ou transféré vers l'unité de traitement 30 à laquelle le contact 26 est connecté.

Chaque signal est alors converti par l'unité de traitement 30.

Le signal converti est fonction de la composante fréquentielle à la fréquence de résonance de la sous-zone.

Le procédé d'analyse permet ainsi d'analyser un signal d'intérêt en utilisant des centres NV du diamant et une détection électrique du signal de résonance magnétique exploitant l'effet photoélectrique (aussi désigné sous l'acronyme PDMR).

Par rapport à une détection optique de la résonance magnétique (aussi désignée sous l'acronyme ODMR), le dispositif 10 est un dispositif 10 plus compact puisqu'aucune unité de lecture optique, notamment un microscope, n'est impliquée.

Selon un mode de réalisation particulier, la distance d_{contact} entre deux contacts 26 est inférieure à 300 nm, ce qui permet d'obtenir une meilleure résolution qu'une détection optique. De fait, une telle distance est inférieure à la limite de résolution optique.

Le dispositif 10 d'analyse permet de faire une détection instantanée de la totalité du signal à analyser. Le dispositif 10 est donc plus rapide qu'un système à balayage classique. De plus, du fait de sa simplicité, le dispositif 10 est moins couteux et plus compact.

Le dispositif 10 d'analyse est ainsi un dispositif à l'état solide, compact et fonctionnant à température ambiante.

Un autre mode de réalisation du dispositif 10 d'analyse est proposé en référence à la figure 2.

Le dispositif 10 d'analyse dans ce cas est similaire au dispositif 10 d'analyse de la figure 1. Les éléments identiques ne sont pas répétés dans ce qui suit. Seules les différences sont soulignées.

Dans un tel cas, chaque contact 26 est formé par deux électrodes interdigitées 32.

Des électrodes interdigitées 32 sont une paire de réseaux en forme de peigne, chaque dent du peigne étant une électrode. Les paires de réseaux sont imbriquées l'une dans l'autre, de sorte qu'entre deux électrodes du premier réseau se trouve une électrode du deuxième réseau.

Comme précédemment, chaque paire de réseau est connectée à une seule unité de traitement 30 du circuit de lecture 28.

En outre, il est à noter que le point milieu est défini comme l'électrode du milieu du réseau d'électrodes interdigitées 32.

Dans l'exemple décrit, une direction peut être définie pour chaque électrode interdigitée 32, les directions étant parallèles.

En outre, les directions sont selon la deuxième direction Y qui est perpendiculaire à la direction d'application du gradient de champ magnétique.

Le fonctionnement du dispositif 10 d'analyse selon la figure 2 est similaire à celui du dispositif 10 de la figure 1 sauf en ce que l'emploi de telles électrodes interdigitées 32 permet d'appliquer en outre un champ d'excitation additionnel. L'amplitude de champ d'excitation correspond à quelques volts.

Le dispositif 10 selon la figure 2 présente les mêmes avantages que le dispositif 10 selon la figure 1.

En outre, du fait que les électrodes sont interdigitées selon la deuxième direction Y, l'encombrement est réduit et l'efficacité de collection des charges est améliorée, ce qui résulte en une amélioration du rapport signal sur bruit du dispositif 10.

Typiquement, une augmentation d'un facteur 50 du signal détecté est attendue.

D'autres modes de réalisation sont envisageables pour améliorer la collection du signal utile.

Notamment, tout mode de réalisation tendant à aligner l'axe des centres NV, la première direction X et la direction de propagation de l'excitation optique ou électrique est favorable pour la collection du signal utile.

Par exemple, pour cela, un cristal 12 de diamant est une couche présentant un axe 111 selon lequel sont alignés les centres NV, l'axe 111 appartenant au plan dans lequel s'étend principalement le cristal 12 de diamant.

A défaut d'avoir un tel cristal 12, il est possible de partir d'un cristal 12 commercial ayant des facettes 110 et d'épaisseur typique de 500 µm. En le taillant de manière adéquate, il est obtenu un cristal 12 de l'ordre de 500 µm de long avec la bonne orientation.

Il est également possible d'utiliser un cristal 12 dont les centres NV sont tous orientés selon un seul axe 111, ce qui peut être obtenu par contrôle de la croissance. Si la qualité cristalline n'est pas suffisante, il est aussi utilisé un cristal 12 dont la croissance est effectuée selon 113 durant la croissance pour bénéficier de l'orientation préférentielle des centres NV et tailler ultérieurement suivant la direction 111.

Avantageusement, le générateur de champ magnétique 18 est configuré pour que l'amplitude du champ magnétique soit constante selon une direction perpendiculaire Z perpendiculaire au plan du cristal 12 ainsi que pour la deuxième direction Y dans le plan du cristal 12. Cette caractéristique est obtenue pour des aimants longs dans la direction perpendiculaire Z et la deuxième direction Y, ce qui impose l'invariance du champ magnétique selon ces directions. Ceci permet à l'intégralité des centres NV situés selon la direction perpendiculaire Z et la deuxième direction Y et ayant la même coordonnée le long de la première direction X d'avoir la même fréquence de résonance. Il est donc possible de sommer toutes leurs contributions pour former le signal de collection, ce qui permet d'augmenter le signal détecté et d'améliorer le rapport signal à bruit.

## Revendications

1. Dispositif (10) d'analyse en fréquence d'un signal comprenant :
- un cristal (12) de diamant présentant une maille cristalline, une bande de valence et une bande de conduction, le cristal (12) comprenant des centres NV dans la maille cristalline, chaque centre NV étant constitué d'un atome d'azote substitué à un atome de carbone et couplé à une lacune, le couple atome d'azote et lacune constituant un centre coloré dans la maille cristalline, le cristal (12) de diamant présentant au moins une zone comportant plusieurs sous-zones ayant chacune une fréquence de résonance entre les niveaux d'énergie du centre NV⁻ dans laquelle, pour chacune des sous-zones, lorsque la sous-zone est en présence d'une excitation optique ou électrique, des charges sont générées dans la bande de conduction, et, en présence d'un signal présentant au moins une fréquence égale à la fréquence de résonance de la sous-zone, la quantité de charges varie avec l'amplitude de la composante fréquentielle du signal à la fréquence de résonance,
- une unité d'excitation (14) propre à exciter optiquement ou électriquement chaque sous-zone,
- une unité d'injection (16) propre à injecter un signal pour que la sous-zone soit en présence du signal,
- un générateur de champ magnétique (18) configuré pour générer un champ magnétique sur chaque sous-zone, le champ magnétique présentant une variation spatiale d'amplitude selon une première direction, et
- un détecteur (20) propre à détecter la fréquence de résonance de chaque sous-zone de la zone, le détecteur (20) étant **caractérisé en ce que** le détecteur (20) comporte :
∘ un contact (26) électrique pour chaque sous-zone dont le détecteur (20) est propre à détecter la fréquence de résonance, chaque contact (26) électrique étant propre à détecter les charges créées dans la sous-zone considérée dans la bande de conduction du cristal (12) pour obtenir un signal lorsque la sous-zone est simultanément en présence d'une excitation optique ou électrique provenant de l'unité d'excitation (14) et d'un signal injecté par l'unité d'injection (16), et
∘ un circuit de lecture (28) en silicium connecté aux contacts (26) pour convertir chaque signal obtenu en un signal converti, chaque signal converti étant fonction de l'amplitude de la composante fréquentielle à la fréquence de résonance de la sous-zone.

2. Dispositif selon la revendication 1, dans lequel la distance entre deux contacts (26) est inférieure à 300 nanomètres.

3. Dispositif selon la revendication 1 ou 2, dans lequel le circuit de lecture (28) est un circuit CMOS.

4. Dispositif selon l'une quelconque des revendications 1 à 3, dans lequel le circuit de lecture (28) comporte une pluralité d'unités de traitement (30), chaque unité de traitement (30) étant reliée à un contact (26) respectif.

5. Dispositif selon à la revendication 4, dans lequel chaque unité de traitement (30) est reliée à un contact (26) respectif par un plot d'indium ou par un fil (31).

6. Dispositif selon l'une quelconque des revendications 1 à 3, dans lequel le détecteur (20) comporte, en outre, un circuit imprimé, le circuit imprimé connectant le circuit de lecture (28) aux contacts (26).

7. Dispositif selon l'une quelconque des revendications 1 à 6, dans lequel chaque contact (26) est formé de deux électrodes interdigitées (32) selon une deuxième direction (Y), la deuxième direction (Y) étant perpendiculaire à la première direction (X).

8. Dispositif selon l'une quelconque des revendications 1 à 7, dans lequel le cristal (12) est une couche s'étendant principalement selon un plan et présentant un axe 111, l'axe 111 appartenant au plan.

9. Dispositif selon l'une quelconque des revendications 1 à 8, dans lequel le nombre de contacts est supérieur à 500.

10. Procédé d'analyse en fréquence d'un signal, le procédé comportant au moins les étapes suivantes :
- fournir un cristal (12) de diamant présentant une maille cristalline, une bande de valence et une bande de conduction, le cristal (12) comprenant des centres NV dans la maille cristalline, chaque centre NV étant constitué d'un atome d'azote substitué à un atome de carbone et couplé à une lacune, le couple atome d'azote et lacune constituant un centre coloré dans la maille cristalline, le cristal (12) présentant au moins une zone comportant plusieurs sous-zones ayant chacune une fréquence de résonance entre les niveaux d'énergie du centre NV⁻ dans laquelle, pour chacune des sous-zones, lorsque la sous-zone est simultanément en présence d'une excitation optique ou électrique et d'un signal présentant au moins une fréquence égale à la fréquence de résonance de la sous-zone, apparaît une modification de la quantité de charges générées dans la bande de conduction ;
- exciter optiquement ou électriquement chaque sous-zone du cristal (12) de diamant,
- injecter un signal pour que la sous-zone soit en présence du signal,
- générer un champ magnétique sur chaque sous-zone, le champ magnétique présentant une variation spatiale d'amplitude selon une première direction (X), et
- détecter la fréquence de résonance de chaque sous-zone de la zone, le procédé étant **caractérisé en ce que** l'étape de détecter la fréquence de résonance de chaque sous-zone de la zone est mise en œuvre en :
- détectant les charges créées dans chaque sous-zone dans la bande de conduction du diamant à l'aide d'un contact (26) électrique propre à chaque sous-zone, pour obtenir un signal et
- convertissant chaque signal obtenu en un signal converti avec un circuit de lecture (28) en silicium connecté aux contacts (26), chaque signal converti étant fonction de la composante fréquentielle du signal à la fréquence de résonance de la sous-zone.

## Patentansprüche

1. - Vorrichtung (10) zur Frequenzanalyse eines Signals, umfassend:
- einen Diamantkristall (12), der ein Kristallgitter, ein Valenzband und ein Leitungsband aufweist, der Kristall (12) umfassend NV-Zentren in dem Kristallgitter, wobei jedes NV-Zentrum aus einem Stickstoffatom besteht, das mit einem Kohlenstoffatom substituiert und an eine Lücke gekoppelt ist, wobei das Paar Stickstoffatom und Lücke ein farbiges Zentrum in dem Kristallgitter bildet, wobei der Diamantkristall (12) mindestens einen Bereich aufweist, der mehrere Unterbereiche umfasst, die jeweils eine Resonanzfrequenz zwischen den Energieniveaus des NV-Zentrums aufweisen, in der, für jeden der Unterbereiche, wenn der Unterbereich in Anwesenheit einer optischen oder elektrischen Erregung ist, Ladungen in dem Leitungsband erzeugt werden, und in Anwesenheit eines Signals, das mindestens eine Frequenz aufweist, die gleich wie die Resonanzfrequenz des Unterbereichs ist, die Menge an Ladungen mit der Amplitude der Frequenzkomponente des Signals bei der Resonanzfrequenz variiert,
- eine Erregungseinheit (14), die geeignet ist, um jeden Unterbereich optisch oder elektrisch zu erregen,
- eine Injektionseinheit (16), die geeignet ist, um ein Signal zu injizieren, damit der Unterbereich das Signal präsent hat,
- einen Magnetfeldgenerator (18), der konfiguriert ist, um ein Magnetfeld über jeden Unterbereich zu erzeugen, wobei das Magnetfeld eine räumliche Variation der Amplitude entlang einer ersten Richtung aufweist, und
- einen Detektor (20), der geeignet ist, um die Resonanzfrequenz von jedem Unterbereich des Bereichs zu erfassen, wobei der Detektor (20) **dadurch gekennzeichnet ist, dass** der Detektor (20) Folgendes umfasst:
o einen elektrischen Kontakt (26) für jeden Unterbereich, dessen Resonanzfrequenz der Detektor (20) erfassen kann, wobei jeder elektrische Kontakt (26) die Ladungen erfassen kann, die in dem jeweiligen Unterbereich in dem Leitungsband des Kristalls (12) erzeugt werden, um ein Signal zu erlangen, wenn der Unterbereich gleichzeitig in Anwesenheit einer optischen oder elektrischen Erregung von der Erregungseinheit (14) und eines von der Injektionseinheit (16) injizierten Signals ist, und
o eine Leseschaltung (28) aus Silizium, die mit den Kontakten (26) verbunden ist, um jedes erlangte Signal in ein umgewandeltes Signal umzuwandeln, wobei jedes umgewandelte Signal abhängig von der Amplitude der Frequenzkomponente bei der Resonanzfrequenz des Unterbereichs ist.

2. - Vorrichtung nach Anspruch 1, wobei der Abstand zwischen zwei Kontakten (26) kleiner als 300 Nanometer ist.

3. - Vorrichtung nach Anspruch 1 oder 2, wobei die Leseschaltung (28) eine CMOS-Schaltung ist.

4. - Vorrichtung nach einem der Ansprüche 1 bis 3, wobei die Leseschaltung (28) eine Vielzahl von Verarbeitungseinheiten (30) umfasst, wobei jede Verarbeitungseinheit (30) mit einem jeweiligen Kontakt (26) verbunden ist.

5. - Vorrichtung nach Anspruch 4, wobei jede Verarbeitungseinheit (30) über ein Indiumpunkt oder einen Draht (31) mit einem jeweiligen Kontakt (26) verbunden ist.

6. - Vorrichtung nach einem der Ansprüche 1 bis 3, wobei der Detektor (20) ferner eine gedruckte Schaltung umfasst, wobei die gedruckte Schaltung die Leseschaltung (28) mit den Kontakten (26) verbindet.

7. - Vorrichtung nach einem der Ansprüche 1 bis 6, wobei jeder Kontakt (26) aus zwei ineinandergreifenden Elektroden (32) entlang einer zweiten Richtung (Y) gebildet ist, wobei die zweite Richtung (Y) senkrecht zu der ersten Richtung (X) ist.

8. - Vorrichtung nach einem der Ansprüche 1 bis 7, wobei der Kristall (12) eine Schicht ist, die sich hauptsächlich in einer Ebene erstreckt und eine Achse 111 aufweist, wobei die Achse 111 zu der Ebene gehört.

9. - Vorrichtung nach einem der Ansprüche 1 bis 8, wobei die Anzahl an Kontakten größer als 500 ist.

10. - Verfahren zur Frequenzanalyse eines Signals, das Verfahren umfassend mindestens die folgenden Schritte:
- Bereitstellen eines Diamantkristalls (12), der ein Kristallgitter, ein Valenzband und ein Leitungsband aufweist, der Kristall (12) umfassend NV-Zentren in dem Kristallgitter, wobei jedes NV-Zentrum aus einem Stickstoffatom besteht, das mit einem Kohlenstoffatom substituiert und an eine Lücke gekoppelt ist, wobei das Paar Stickstoffatom und Lücke ein farbiges Zentrum in dem Kristallgitter bildet, wobei der Kristall (12) mindestens einen Bereich aufweist, der mehrere Unterbereiche umfasst, die jeweils eine Resonanzfrequenz zwischen den Energieniveaus des NV-Zentrums aufweisen, in der für jeden der Unterbereichs, wenn der Unterbereich gleichzeitig in Anwesenheit einer optischen oder elektrischen Erregung und eines Signals mit mindestens einer Frequenz gleich der Resonanzfrequenz des Unterbereichs ist, eine Änderung der Menge an Ladungen, die in dem Leitungsband erzeugt werden, auftritt;
- Optisches oder elektrisches Erregen von jedem Unterbereich des Diamantkristalls (12),
- Injizieren eines Signals, damit der Unterbereich das Signal präsent hat,
- Erzeugen eines Magnetfelds über jeden Unterbereich, wobei das Magnetfeld eine räumliche Variation der Amplitude entlang einer ersten Richtung (X) aufweist, und
- Erfassen der Resonanzfrequenz von jedem Unterbereich des Bereichs, wobei das Verfahren **dadurch gekennzeichnet ist, dass** der Schritt eines Erfassens der Resonanzfrequenz von jedem Unterbereich des Bereichs durchgeführt wird, durch:
- Erfassen der Ladungen, die in jedem Unterbereich in dem Leitungsband des Diamanten erzeugt werden, mittels eines elektrischen Kontakts (26), der jedem Unterbereich eigen ist, um ein Signal zu erlangen, und
- Umwandeln von jedem erlangten Signal in ein umgewandeltes Signal mit einer Leseschaltung (28) aus Silizium, die mit den Kontakten (26) verbunden ist, wobei jedes umgewandelte Signal abhängig von der Frequenzkomponente des Signals bei der Resonanzfrequenz des Unterbereichs ist.

## Claims

1. A device (10) for frequency analysis of a signal, comprising:
- a diamond crystal (12) having a crystal lattice, a valence band and a conduction band, the crystal (12) comprising NV centers in the crystal lattice, each NV center being made up of a nitrogen atom substituted for a carbon atom and coupled to a vacancy, the nitrogen atom and vacancy pair making up a colored center in the crystal lattice, the diamond crystal (12) having at least one region including several sub-regions each having a resonance frequency between the energy levels of the NV⁻ center in which, for each of the sub-regions, when the sub-region is in the presence of an optical or electric excitation, charges are generated in the conduction band, and, in the presence of a signal having at least one frequency equal to the resonance frequency of the sub-regions, the quantity of charges varies with the amplitude of the frequency component of the signal at the resonance frequency,
- an excitation unit (14) for optically or electrically exciting each sub-region,
- an injection unit (16) for injecting a signal for the sub-region to be in the presence of the signal,
- a magnetic field generator (18) configured to generate a magnetic field on each sub-region, the magnetic field having a spatial variation of amplitude in a first direction, and
- a detector (20) adapted to detect the resonance frequency of each sub-region of the region, the detector (20) being **characterized in that** the detector (20) includes:
∘ an electrical contact (26) for each sub-region whose detector (20) is adapted to detect the resonance frequency, each electrical contact (26) being able to detect the charges created in the sub-region in question in the conduction band of the crystal (12) in order to obtain a signal when the sub-region is simultaneously in the presence of an optical or electrical excitation coming from the excitation unit (14) and a signal injected by the injection unit (16), and
∘ a silicon reading circuit (28) connected to the contacts (26) in order to convert each obtained signal into a converted signal, each converted signal depending on the amplitude of the frequency component at the resonance frequency of the sub-region.

2. The device according to claim 1, wherein the distance between two contacts (26) is less than 300 nanometers.

3. The device according to claim 1 or 2, wherein the reading circuit (28) is a CMOS circuit.

4. The device according to any one of claims 1 to 3, wherein the reading circuit (28) includes a plurality of processing units (30), each processing unit (30) being connected to a respective contact (26).

5. The device according to claim 4, wherein each processing unit (30) is connected to a respective contact (26) by an indium pad or by a wire (31).

6. The device according to any one of claims 1 to 3, wherein the detector (20) further includes a printed circuit board, the printed circuit board connecting the reading circuit (28) to the contacts (26).

7. The device according to any one of claims 1 to 6, wherein each contact (26) is formed by two electrodes (32) interdigitated in a second direction (Y), the second direction (Y) being perpendicular to the first direction (X).

8. The device according to any one of claims 1 to 7, wherein the crystal (12) is a layer extending primarily along a plane and having an axis 111, the axis 111 belonging to the plane.

9. The device according to any one of claims 1 to 8, wherein the number of contacts is greater than 500.

10. A method for the frequency analysis of a signal, the method including at least the following steps:
- providing a diamond crystal (12) having a crystal lattice, a valence band and a conduction band, the crystal (12) comprising NV centers in the crystal lattice, each NV center being made up of a nitrogen atom substituted for a carbon atom and coupled to a vacancy, the nitrogen atom and vacancy pair making up a colored center in the crystal lattice, the crystal (12) having at least one region including several sub-regions each having a resonance frequency between the energy levels of the NV⁻ center in which, for each of the sub-regions, when the sub-region is simultaneously in the presence of an optical or electric excitation and a signal having at least one frequency equal to the resonance frequency of the subregion, a change in the quantity of charges generated in the conduction band appears;
- optically or electrically exciting each sub-region of the diamond crystal (12),
- injecting a signal so that the sub-region is in the presence of the signal,
- generating a magnetic field on each sub-region, the magnetic field having a spatial variation of amplitude in a first direction (X), and
- detecting the resonance frequency of each sub-region of the region, the method being characterizedin that the step for detecting the resonance frequency of each sub-region of the region is carried out by:
- detecting the charges created in each sub-region in the conduction band of the diamond using an electrical contact (26) specific to each sub-region, in order to obtain a signal and
- converting each obtained signal into a converted signal with a silicon reading circuit (28) connected to the contacts (26), each converted signal depending on the frequency component of the signal at the resonance frequency of the sub-region.
